(19) Europäisches Patentamt
European Patent Office
Office européen des brevets

(11) Veröffentlichungsnummer: **0 424 766 A2**

# (12) EUROPÄISCHE PATENTANMELDUNG

(21) Anmeldenummer: **90119671.7**

(51) Int. Cl.$^5$: **G03F 7/004**

(22) Anmeldetag: **15.10.90**

(30) Priorität: **27.10.89 DE 3935875**

(43) Veröffentlichungstag der Anmeldung:
**02.05.91 Patentblatt 91/18**

(84) Benannte Vertragsstaaten:
**CH DE FR GB IT LI NL**

(71) Anmelder: **BASF Aktiengesellschaft**
**Carl-Bosch-Strasse 38**
**W-6700 Ludwigshafen(DE)**

(72) Erfinder: **Nguyen Kim, Son, Dr.**
**Zedernweg 9**
**W-6944 Hemsbach(DE)**

## (54) Strahlungsempfindliches Gemisch und Verfahren zur Herstellung von Reliefmustern.

(57) Die Erfindung betrifft ein strahlungsempfindliches Gemisch, das im wesentlichen besteht aus

(a) einem in Wasser unlöslichen, in wäßrig-alkalischen Lösungen löslichen Bindemittel oder Bindemittelgemisch,

(b) einer bei Bestrahlung eine starke Säure bildenden Verbindung, und

(c) einer organischen Verbindung die eine durch Säure spaltbare Carbamateinheit enthält.

Dieses strahlungsempfindliche Gemisch eignet sich zur Herstellung von Reliefstrukturen.

EP 0 424 766 A2

# STRAHLUNGSEMPFINDLICHES GEMISCH UND VERFAHREN ZUR HERSTELLUNG VON RELIEFMUSTERN

Die Erfindung betrifft positiv arbeitende strahlungsempfindliche Gemische, die ein in Wasser unlösliches, in wäßrig-alkalischen Lösungen lösliches Bindemittel, eine unter Einwirkung von Strahlung eine Säure bildende Verbindung und Carbamatgruppierungen enthalten, sowie ein Verfahren zur Herstellung von Reliefmustern. Die erfindungsgemäßen Gemische sind sensitiv gegenüber UV-, Elektronen- und Röntgenstrahlen und eignen sich besonders als Resistmaterial.

Positiv arbeitende strahlungsempfindliche Gemische sind bekannt. Positiv arbeitende Resistmaterialien, die o-Chinondiazide in wäßrig-alkalisch löslichen Bindemitteln, z.B. Novolaken oder Poly(p-vinylphenol)en, enthalten, werden kommerziell eingesetzt. Die Empfindlichkeit dieser Systeme gegenüber Strahlung, insbesondere kurzwelliger Strahlung, ist jedoch teilweise unbefriedigend.

Empfindlichkeitserhöhungen in strahlungsempfindlichen Systemen, die in der Primärphotoreaktion eine Spezies erzeugen, die dann unabhängig von der Strahlung eine katalytische Sekundärreaktion auslösen, sind ebenfalls beschrieben. So sind in der US-A 3,915,706 beispielsweise Photoinitiatoren beschrieben, die eine starke Säure erzeugen, die dann in einer Sekundärreaktion säurelabile Gruppen, wie Polyaldehydgruppierungen spalten.

Weiterhin sind strahlungsempfindliche Gemische auf Basis von säurespaltbaren Verbindungen bekannt, die als Bindemittel ein wäßrig-alkalisch lösliches Polymer sowie eine Verbindung, die photochemisch eine starke Säure bildet, und eine weitere Verbindung mit durch Säure spaltbaren Bindungen, die durch die Einwirkung der Säure ihre Löslichkeit in einem alkalischen Entwickler erhöhen, enthalten (vgl. DE-A 3 406 927). Als photochemisch eine starke Säure bildende Verbindungen werden Diazonium-, Phosphonium-, Sulfonium- und Iodonium-, sowie Halogenverbindungen genannt. Die Verwendung dieser Oniumsalze als photochemische Säurespender in Resistmaterialien ist z.B. auch aus US-A 4,491,628 bekannt. Einen Überblick über die Anwendung von Oniumsalzen in Resistmaterialien gibt Crivello in Org. Coatings and Appl. Polym. Sci., 48, p. 65-69 (1985).

Strahlungsempfindliche Gemische von Polymeren mit säurelabilen Seitengruppen und photochemischen Säurespendern sind z.B. aus US-A 4,491,628, FR-A 2,570,844 und Polymeric Material Science and Engineering, A.C.S., Vol. 61, 417-421 (1989) bekannt. Diese polymeren Bindemittel sind jedoch hydrophob und werden erst nach der Belichtung alkalilöslich.

Copolymere mit phenolischen und säurelabilen Gruppen, wie beispielsweise Poly-(p-hydroxistyrol-co-t-butoxicarbonyloxistyrol), sind aus J. Polym. Sci., Part A, Polym. Chem. Ed., Vol. 24, 2971-2980 (1986) bekannt. Verwendet man jedoch diejenigen Copolymeren dieser Gruppe, die noch alkalilöslich sind, in Verbindung mit den kommerziellen Sulfoniumsalzen, wie Triphenylphosphoniumhexafluoroarsenat, wie auch in US-A 4,491,628 beschrieben, so haben diese Gemische den Nachteil, daß ein sehr hoher Abtrag der unbelichteten Bereiche stattfindet, da die genannten Sulfoniumsalze nicht genügend zur Löslichkeitsinhibierung beitragen.

In der DE-A 37 21 741 werden strahlungsempfindliche Gemische beschrieben, die ein in wäßrig-alkalischen Lösungen lösliches polymeres Bindemittel enthalten sowie eine organische Verbindung, deren Löslichkeit in einem wäßrig-alkalischen Entwickler durch Einwirkung von Säure erhöht wird und die mindestens eine durch Säure spaltbare Gruppierung enthält, wobei diese organische Verbindung unter Einwirkung von Strahlung eine starke Säure erzeugt.

Aufgabe der vorliegenden Erfindung ist es, neue positiv arbeitende hochaktive strahlungsempfindliche Systeme für die Herstellung von Reliefstrukturen aufzuzeigen, die sich mit wäßrig-alkalischen Lösungen entwickeln lassen und die Herstellung von im kurzwelligen UV lichtempfindlichen Schichten ermöglichen.

Überraschenderweise wurde gefunden, daß sich durch die Einbeziehung von Carbamatgruppierungen hochaktive strahlungsempfindliche Systeme für die Herstellung von Reliefstrukturen im kurzwelligen UV herstellen lassen, die sich durch sehr gute Reproduzierbarkeit und hohe Auflösung auszeichnen.

Gegenstand der vorliegenden Erfindung ist ein strahlungsempfindliches Gemisch, im wesentlichen bestehend aus

(a) einem in Wasser unlöslichen, in wäßrig-alkalischen Lösungen löslichen Bindemittel oder Bindemittelgemisch

und

(b) einer bei Bestrahlung eine starke Säure bildenden Verbindung, das dadurch gekennzeichnet ist, daß das Gemisch zusätzlich eine organische Verbindung (c) enthält, die eine durch Säure spaltbare Carbamateinheit

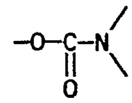

aufweist
oder
die Komponente (a) oder die Komponente (b) eine durch Säure spaltbare Carbamateiheit

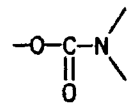

enthält.

Als Bindemittel (a) kommen beispielsweise phenolische Harze in Betracht, insbesondere Novolake mit einem mittleren Molekulargewicht $\overline{M}_w$ zwischen 300 und 30.000, sowie vorzugsweise Poly-(p-hydroxistyrol), Poly-(p-hydroxi-α-methylstyrol) oder Copolymerisate des p-Hydroxistyrols, deren mittlere Molekulargewichte $\overline{M}_w$ zwischen 200 und 200.000 liegen.

Als bei Bestrahlung eine starke Säure bildende Verbindungen (b) werden insbesondere Sulfoniumsalze der allgemeinen Formel (I)

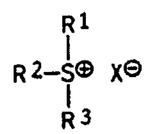 (I)

eingesetzt wird, worin $R^1$, $R^2$ und $R^3$ untereinander gleich oder verschieden sind und für Alkyl mit 1 bis 3 Kohlenstoffatomen, Aryl, substituiertes Aryl oder Aralkyl stehen, und $X^{\ominus}$ = $ClO_4^{\ominus}$, $AsF_6^{\ominus}$, $SbF_6^{\ominus}$, $PF_6^{\ominus}$, $BF_4^{\ominus}$ und/oder $CF_3SO_3^{\ominus}$ ist; wobei solche Sulfoniumsalze der allgemeinen Formel (I) bevorzugt sind, in denen mindestens einer der Reste $R^1$, $R^2$ und $R^3$ den Rest

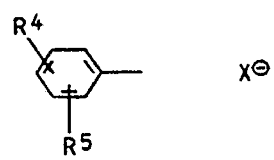

bedeutet, worin $R^4$ und $R^5$ untereinander gleich oder verschieden sind und für H, OH oder den Rest

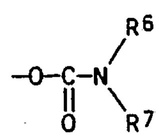

stehen, worin $R^6$ und $R^7$ untereinander gleich oder verschieden sind und für H oder Alkyl mit 1 bis 5 Kohlenstoffatomen stehen, oder $R^6$ mit $R^7$ zu einem fünf- oder sechsgliedrigen, gegebenenfalls ein oder mehrfach substituierten, heterocyclischen Ring verbunden ist.

Die erfindungsgemäßen strahlungsempfindlichen Gemische enthalten die bei Bestrahlung eine starke Säure bildende Verbindung (b) im allgemeinen in einer Menge von 1 bis 30 Gew.-%, bezogen auf die Gesamtmenge der Stoffe (a) + (b).

Als zusätzliche organische Verbindungen (c), die eine durch Säure spaltbare Carbamateinheit

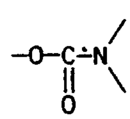

aufweist, werden vorzugsweise Verbindungen der allgemeinen Formel (II) eingesetzt

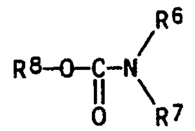

(II),

worin $R^6$ und $R^7$ untereinander gleich oder verschieden sind und für H oder Alkyl mit 1 bis 5 Kohlenstoffatomen stehen, oder $R^6$ mit $R^7$ zu einem fünf- oder sechsgliedrigen, gegebenenfalls ein- oder mehrfach substituierten, heterocyclischen Ring verbunden ist und $R^8$ ein geradkettiger oder verzweigter Alkylrest mit 1 bis 10 Kohlenstoffatomen, ein halogenhaltiger geradkettiger oder verzweigter Alkylrest mit 1 bis 10 Kohlenstoffatomen, ein Phenylrest, ein Alkyl-, Alkoxy- oder Halogenphenylrest, ein Phenalkylrest mit 1 bis 3 Kohlenstoffatomen in der Alkylgruppe, ein Halogen- oder Alkoxyphenalkylrest mit 1 bis 3 Kohlenstoffatomen in der Alkylgruppe oder ein durch einen heterocyclischen Rest substituierten Methyl- oder Ethylrest ist.

Die erfindungsgemäßen Gemische können zusätzlich als Sensibilisator eine polycyclische aromatische Verbindung enthalten, die Strahlung absorbieren und auf die bei Bestrahlung eine starke Säure bildende Verbindung (b) übertragen.

Gegenstand der vorliegenden Erfindung ist außerdem ein Verfahren zur Herstellung von Reliefstrukturen oder Reliefmustern durch Auftragen von Photoresistlösungen in einer Schichtdicke von 0,1 bis 5 µm auf ein in üblicher Weise vorbehandeltes Substrat, Trocknen, bildmäßige Bestrahlung, Erhitzen auf Temperaturen von 50 zu 150 °C und Entwickeln mit einer wäßrig alkalischen Lösung, wobei Photoresistlösungen eingesetzt werden, die erfindungsgemäße strahlungsempfindliche Gemische enthalten.

Zu den Aufbaukomponenten des erfindungsgemäßen strahlungsempfindlichen Gemisches ist im einzelnen weiterhin folgendes auszuführen.

(a) Wegen der erwünschten Plasmaätzstabilität werden als in Wasser unlösliche, in wäßrig-alkalischen Lösungen lösliche oder zumindest dispergierbare Bindemittel (a) besonders phenolische Harze eingesetzt, wie z.B. Novolake, wie sie beispielsweise in "Novolak Resins used in Positive Resist System" (T. Pampalone in "solid State Technology, June 1984, Seiten 115 - 120 beschrieben sind, wobei für die Bestrahlung im Kurzwelligen UV-Bereich ($\lambda \leq 300$ nm) bevorzugt Novolake auf Basis p-Kresol/Formaldehyd in Frage kommen. Bevorzugt sind insbesondere Poly-(p-hydroxistyrole), Poly-(p-hydroxi-α-methylstyrole) sowie Copolymerisate des p-Hydroxistyrols.

Sofern Carbamatgruppen im Bindemittel (a) enthalten sind, können diese durch folgendes allgemeines Formelschema dargestellt werden:

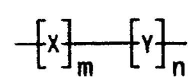

worin
$m \geqq n$
X = phenolische Monomereinheit,
wie z.B. p-Hydroxistyrol oder p-Hydroxi-α-methyl-styrol,
v = Monomereinheit mit einer

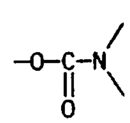

Gruppe,
wie z.B. N-Alkoxicarbonylmaleinimid der Formel

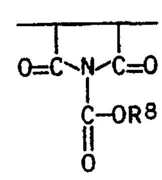

oder mit Carbamat modifizierte p-Hydroxistyroleinheiten der Formeln

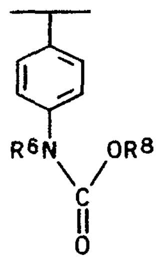

bzw.

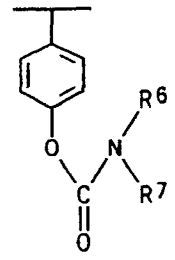

wobei die Reste $R^6$, $R^7$ und $R^8$ die oben bereits angegebene Bedeutungen haben können.

Komponente (a) ist im erfindungsgemäßen strahlungsempfindlichen Gemisch im allgemeinen in Mengen von 70 bis 99, vorzugsweise bis 75 bis 95 Gew.-%, bezogen auf die Gesamtmenge des Gemisches aus (a) + (b) + (c), enthalten.

(b) Als Säurespender können im Prinzip alle bei Bestrahlung eine starke Säure bildende Verbindungen eingesetzt werden. Für die Bestrahlung mit kurzwelligem UV sind jedoch Sulfoniumsalze der allgemeinen Formel (I)

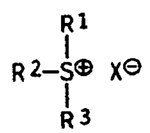 (I)

bevorzugt, worin $R^1$, $R^2$ und $R^3$ untereinander gleich oder verschieden sind und für Alkyl mit 1 bis 3 Kohlenstoffatomen, wie z.B. Methyl und Ethyl, Aryl, wie z.B. Phenyl, oder Aralkyl, wie z.B. Benzyl stehen und $X^{\ominus}$ die Anionen $ClO_4^{\ominus}$, $AsF_6^{\ominus}$, $SbF_6^{\ominus}$, $PF_6^{\ominus}$, $BF_4^{\ominus}$ und/oder $CF_3SO_3^{\ominus}$ sein können.

Bevorzugt sind insbesondere solche Sulfoniumsalze der allgemeinen Formel (I), in denen mindestens einer der Reste $R^1$, $R^2$ und $R^3$ den Rest

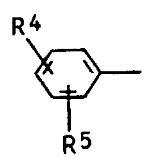

bedeutet, worin $R^4$ und $R^5$ untereinander gleich oder verschieden sind und für H, OH oder der Rest

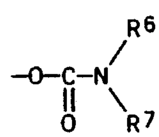

stehen, worin $R^6$ und $R^7$ untereinander gleich oder verschieden sind und für Wasserstoff, geradkettiges Alkyl mit 1 bis 10, vorzugsweise 1 bis 5 Kohlenstoffatomen, z.B. Methyl, Ethyl, verzweigtes Alkyl mit 3 bis 10, vorzugsweise 3 bis 5 Kohlenstoffatomen, wobei die Alkylgruppen auch mit Halogen, wie z. B. Chlor, Brom, vorzugsweise Chlor, OH, SH, Alkoxi mit 1 bis 4 Kohlenstoffatomen, wie z.B. Methoxid, Ethoxi, O-Aryl, O-Aralkyl, Alkylthio mit 1 bis 4 Kohlenstoffatomen, S-Aryl, wie S-Phenyl oder S-Aralkyl wie z.B. S-Benzyl substituiert sein können,
Aryl, wie z. B. Phenyl,
halogensubstituiertes Aryl, wie z. B. Chlorphenyl, Bromphenyl,
Alkylsubstituietes Aryl, wie z. B. Tolyl,
alkoxysubstituiertes Aryl, wie z. B. Methoxyphenyl,
Aralkyl, wie z. B. Benzyl, Phenylethyl,
stehen oder $R^6$ mit $R^7$ miteinander zu einem stickstoffhaltigen heterocyclischen Rest mit 5 bis 8,

vorzugsweise 5 bis 6 Ringgliedern verknüpft ist, so daß sich beispielsweise - unter Einbeziehung des Amidstickstoffs der Carbamatgruppe - Ringe wie

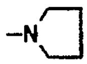 , 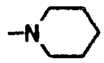 , 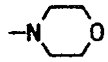 , 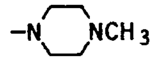 , 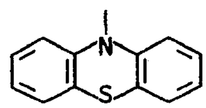

ergeben; $R^6$ und/oder $R^7$ können auch für Acyl stehen, so daß sich - unter Einbeziehung des N der Carbamatgruppe - beispielsweise folgende Reste ergeben:

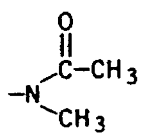 , 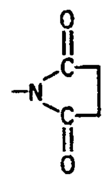 , 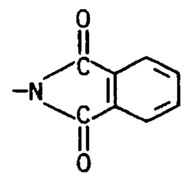

oder

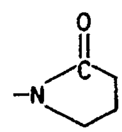

Als Gegenionen $X^{\ominus}$ kommen beispielsweise in Frage $ClO_4^{\ominus}$, $AsF_6^{\ominus}$, $SbF_6^{\ominus}$, $CF_3SO_3^{\ominus}$ (= Triflat), $PF_6^{\ominus}$ und $BF_4^{\ominus}$.

Bevorzugte Sulfoniumsalze sind insbesondere
Triphenylsulfoniumhexafluoroarsenat,
Dimethyl-4-hydroxy-phenylsulfoniumtriflat und
Dimethyl-4-hydroxy-3,5-dimethylphenylsulfoniumhexafluoroarsenat.

An weiteren Säurespendern (b) seien beispielsweise Jodoniumsalze der allgemeinen Formel

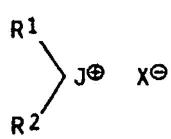

genannt, worin $R^1$, $R^2$ und $X^{\ominus}$ die gleiche Bedeutung wie in der allgemeinen Formel (I) haben.

Die bei Bestrahlung eine starke Säure bildenden Verbindungen, von denen die obengenannten Sulfoniumsalze bevorzugt sind, sind im erfindungsgemäßen strahlungsempfindlichen Gemisch im allgemeinen in einer Menge von 1 bis 30, vorzugsweise 3 bis 10 Gew.-%, bezogen auf die Gesamtmenge von (a) + (b) + (c) enthalten.

(c) Als organische Verbindungen (c) kommen solche in Betracht die mindestens eine durch Säure spaltbare Carbamateinheit

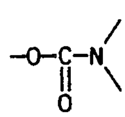

enthalten.

Bevorzugt sind Verbindungen der allgemeinen Formel (II)

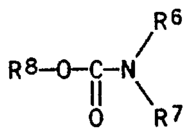 (II),

worin $R^6$ und $R^7$ untereinander gleich oder verschieden sind und für Wasserstoff, einen geradkettigen Alkylrest mit 1 bis 10, vorzugsweise 1 bis 5 Kohlenstoffatomen, wie z. B. Methyl, Ethyl, Propyl, n-Butyl, n-Pentyl, einen verzweigten Alkylrest mit 3 bis 10, vorzugsweise 3 bis 5 Kohlenstoffatomen, wie z. B., Isopropyl, Isobutyl, einen entsprechenden Alkylrest, der mit Halogen, wie Chlor, Brom, OH, SH, Alkoxyl oder Thioalkyl mit 1 bis 5 Kohlenstoffatomen substituiert ist, einen Arylrest, wie z. B. Phenyl, einen Aralkylrest, wie z. B. Benzyl, Phenylethyl, einen durch Alkyl, Alkoxy oder Halogen ein- oder mehrfach substituieten Aryl- oder Aralkylrest, wie z. B. Tolyl, Methoxyphenyl, 4-Methoxybenzyl, 4-Chlorbenzyl, oder $R^6$ und $R^7$ miteinander zu einem stickstoffhaltigen heterocyclischen Rest mit 5 bis 8, vorzugsweise 5 bis 6 Ringgliedern verknüpft ist, so daß sich beispielsweise - unter Einbeziehung des Amidstickstoffs der Carbamatgruppe - Ringe wie

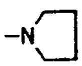 , 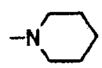 , 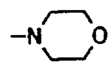 , 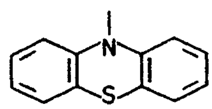 oder

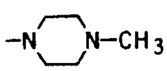 ergeben;

$R^6$ und $R^7$ können auch für Acyl stehen, so daß sich - unter Einbeziehung des N der Carbamatgruppe - beispielsweise die Reste

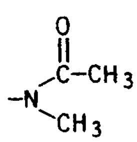 , 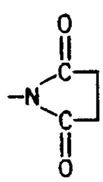 , 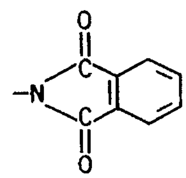

oder

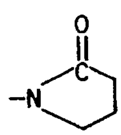

ergeben.

Ebenso können die Reste $R^6$ und $R^7$ auch eine Polymerkette bedeuten, z. B. die Einheiten

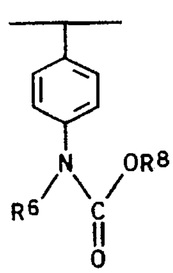 oder 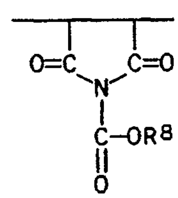

$R^8$ kann ein geradkettiger Alkylrest mit 1 bis 10 vorzugsweise 1 bis 5 Kohlenstoffatomen, beispielsweise Methyl, Ethyl, Propyl, n-Butyl, n-Pentyl, ein verzweigter Alkylrest mit 3 bis 10, vorzugsweise 3 bis 5 Kohlenstoffatomen, beispielsweise Isopropyl, Isobutyl, ein tertiärer Alkylrest mit 4 bis 10 Kohlenstoffatomen, beispielsweise tert.-Butyl, wobei die vorgenannten Alkylreste auch halogensubstituiert, d. h. durch Halogen,

wie Chlor, Brom, vorzugsweise Chlor ein- oder mehrfach substituiert sein können,- wie z. B. β-Chlorethyl, β-Bromethyl, β-Trichlorethyl, β-Chlorisopropyl, β-Trichlorisopropyl,
ein Arylrest, wie Phenyl, Biphenyl,
ein halogensubstituierter Arylrest, wie z. B. Chlorphenyl,
ein Aralkylrest, wie z. B. Benzyl, Phenylethyl,
ein halogensubstituierter Aralkylrest, z. B. am Benzolring, halogensubstituiertes, z. B. chlorsubstituiertes oder mit Alkoxygruppen substituiertes Benzyl sein.

Die Menge, die von Komponente (c) im erfindungsgemäßen strahlungsempfindlichen Gemisch enthalten ist, hängt davon ab, ob und wieviel Carbamatgruppen in den Komponenten (a) und/oder (b) enthalten sind. Für den Fall, daß weder Komponente (a) noch Komponente (b) Carbamatgruppen enthält, beträgt der Anteil an Komponente (c) im erfindungsgemäßen strahlungsempfindlichen Gemisch 5 bis 40, vorzugsweise 15 bis 30 Gew.-%., bezogen auf die Gesamtmenge der Komponenten (a) + (b) + (c).

Die Herstellung der Carbamatgruppe

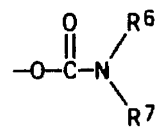

kann nach einer der folgenden aufgeführten Methoden erfolgen:

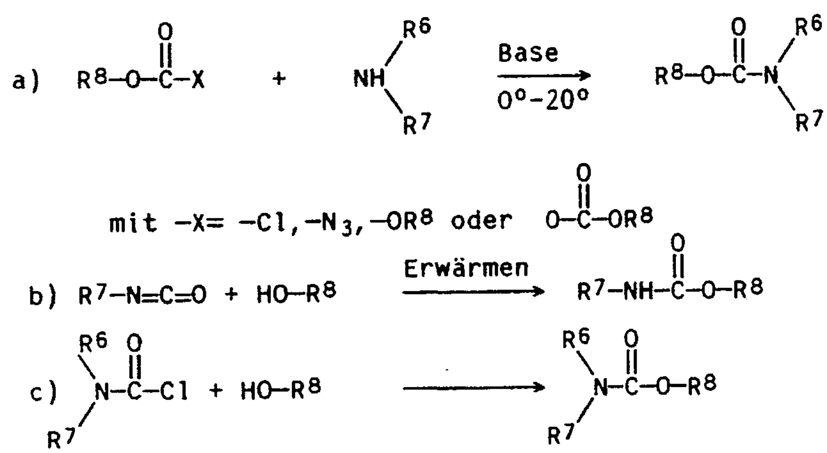


Die erfindungsgemäßen Gemische werden bevorzugt in einem organischen Lösungsmittel gelöst, wobei der Feststoffgehalt im allgemeinen im Bereich zwischen 5 und 40 Gew.-% liegt. Als Lösungsmittel kommen bevorzugt aliphatische Ketone, Ether, sowie Mischungen derselben in Frage, besonders Ethyl-cellosolve, Butylglykol, Methyl-cellosolve und 1-Methoxy-2-propanol, Alkylenglykol-alkylether-ester, wie beispielsweise Methyl-cellosolve-acetat, Ethyl-cellosolve-acetat, Methyl-propylenglykol-acetat und Ethyl-propylenglykol-acetat, Ketone wie beispielsweise Cyclohexanon, Cyclopentanon und Methyl-ethyl-keton sowie Acetate, wie Butylacetat und Aromaten, wie Toluol und Xylol. Die Auswahl der entsprechenden Lösungsmittel, sowie deren Mischung richtet sich nach der Wahl des jeweiligen phenolischen Polymers, Novolaks und der photoempfindlichen Komponente.

Weiterhin können andere Zusätze wie Haftvermittler , Netzmittel, Farbstoffe und Weichmacher zugesetzt werden.

Gegebenenfalls können auch Sensibilisatoren in geringen Mengen zugesetzt werden, um die Verbindungen im längerwelligen UV- bis hin zum sichtbaren Bereich zu sensibilisieren. Polycyclische Aromaten, wie Pyren und Perylen sind hierfür bevorzugt, jedoch können auch andere Farbstoffe, die als Sensibilisatoren wirken, verwendet werden.

Die Lösung des strahlungsempfindlichen Gemisches kann durch ein Filter mit einem Porendurchmesser von 0,2 µm filtriert werden. Durch Aufschleudern der Resistlösung bei Umdrehungszahlen zwischen 1000 und 10 000 U/min wird ein Resistfilm einer Schichtdicke von 0,1 bis 5 µm auf einem Wafer (z.B. ein an der Oberfläche oxidierter Silicium-Wafer) erzeugt. Der Wafer wird dann zwischen 1 und 5 Minuten bei 90 °C bzw. 80 °C ausgeheizt.

Bei dem erfindungsgemäßen Verfahren zur Herstellung von Reliefmustern wird eine strahlungsempfindliche Aufzeichnungsschicht, die im wesentlichen aus dem erfindungsgemäßen strahlungsempfindlichen Gemisch besteht, bildmäßig in solcher Dosis bestrahlt, daß die Löslichkeit der belichteten Bereiche nach einem thermischen Ausheizschritt bei Temperaturen zwischen 60 °C und 120 °C in wäßrig-alkalischen Lösungsmitteln zunimmt und diese Bereiche selektiv mit dem alkalischen Entwickler entfern werden können.

Die Resistfilme werden im allgemeinen durch eine chrombeschichtete strukturierte Quarzmaske mit UV-Licht einer Quecksilberlampe, mit Excimer-Laserlicht, Elektronen- oder Röntgenstrahlen bestrahlt. Die bildmäßig bestrahlten Filme werden zwischen 5 Sekunden und 2 Minuten bei Temperaturen zwischen 60 °C und 110 °C ausgeheizt und hierauf mit wäßrig-alkalischen Entwicklern entwickelt, wobei sich die belichteten Bereiche selektiv ablösen, während in den unbelichteten Bereichen nur wenig Abtrag stattfindet.

Die in den Beispielen genannten Teile und Prozente sind, soweit nicht anders angegeben, Gewichtsteile bzw. Gewichtsprozente.

Beispiel 1

Eine Photoresistlösung wird aus 80 Teilen Poly(p-hydroxistyrol) (= kommerzielles Produkt der Fa. Polysciences, $\overline{M}_w$ = 1500 bis 7000 g/mol) 5 Teilen Triphenylsulfoniumhexafluoroarsenat (= kommerzielles Produkt der Fa. Alfa), 15 Teilen N-Ethoxicarbonylmorpholin und 280 Teilen Methylglykolacetat hergestellt. Die Lösung wird anschließend durch ein Filter mit einem Porendurchmesser von 0,2 µm filtriert.

Die Resistlösung wird auf einen oxidierten Siliciumwafer in 1 µm-Schichtdicke aufgeschleudert. Der Wafer wird dann eine Minute bei 90 °C getrocknet und anschließend mit einer Testmaske im Kontaktverfahren 7 Sekunden mit Excimer-Laserlicht der Wellenlänge λ = 248 nm belichtet. Danach wird 30 Sekunden bei 90 °C ausgeheizt und mit einem Entwickler von pH-Wert 12,0 bis 13,5 etwa 20 Sekunden entwickelt.

Beispiel 2

Eine Photoresistlösung wird aus 80 Teilen Poly(p-hydroxistyrol), 5 Teilen Triphenylsulfoniumhexafluoroarsenat, 15 Teilen N-2-Trichlorethyl-oxicarbonylpyrrolidon und 280 Teilen Methylglycolacetat hergestellt. Es wird wie in Beispiel 1 verfahren. Die Empfindlichkeit für 1 µm-Schichtdicke beträgt 175 mJ/cm$^2$.

Beispiel 3

Eine Photoresistlösung wird aus 80 Teilen Poly(p-hydroxistyrol), 5 Teilen Triphenylsulfoniumhexafluoroarsenat, 15 Teilen t-Butyl-N,N-diethylcarbamat und 280 Teilen Methylglykolacetat hergestellt. Es wird wie in Beispiel 1 verfahren. Die Empfindlichkeit für 1 µm-Schichtdicke beträgt 80 mJ/cm$^2$.

Beispiel 4

Eine Photoresistlösung wird aus 95 Teilen Poly(p-hydroxistyrol-co-20 mol.-% N-Chlorethyloxi-carbonylmaleinimid), 5 Teilen Triphenylsulfoniumhexafluoroarsenat und 300 Teilen Ethylglykolacetat hergestellt. Es wird wie in Beispiel 1 verfahren. Die Empfindlichkeit für 1 µm Schichtdicke beträgt 150 mJ/cm$^2$.

## Ansprüche

1. Strahlungsempfindliches Gemisch, im wesentlichen bestehend aus
(a) einem in Wasser unlöslichen, in wäßrig-alkalischen Lösungen löslichen Bindemittel oder Bindemittelgemisch
und
(b) einer bei Bestrahlung eine starke Säure bildenden Verbindung,
dadurch gekennzeichnet, daß das Gemisch zusätzlich eine organische Verbindung (c) enthält, die eine durch Säure spaltbare Carbamateinheit

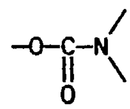

aufweist
oder
die Komponente (a) oder die Komponente (b) eine durch Säure spaltbare Carbamateinheit

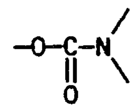

enthält.

2. Strahlungsempfindliches Gemisch nach Anspruch 1, dadurch gekennzeichnet, daß als Bindemittel (a) ein phenolisches Harz eingesetzt wird.

3. Strahlungsempfindliches Gemisch nach Anspruch 2, dadurch gekennzeichnet, daß als phenolisches Harz ein Novolak mit einem mittleren Molekulargewicht $\overline{M}_w$ zwischen 300 und 30.000 eingesetzt wird.

4. Strahlungsempfindliches Gemisch nach Anspruch 1 oder 2, dadurch gekennzeichnet, daß als Bindemittel (a) Poly-(p-hydroxistyrol), Poly-(p-hydroxi-α-methylstyrol) oder ein Copolymerisat des p-Hydroxistyrols eingesetzt wird, wobei das mittlere Molekulargewicht $\overline{M}_w$ des Bindemittels (a) zwischen 200 und 200.000 beträgt.

5. Strahlungsempfindliches Gemisch nach einem der vorhergehenden Ansprüche, dadurch gekennzeichnet, daß als bei Bestrahlung eine starke Säure bildende Verbindung (b) ein Sulfoniumsalz der allgemeinen Formel (I)

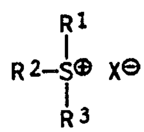 (I)

eingesetzt wird, worin $R^1$, $R^2$ und $R^3$ untereinander gleich oder verschieden sind und für Alkyl mit 1 bis 3 Kohlenstoffatomen, Aryl, substituiertes Aryl oder Aralkyl stehen, und $X^{\ominus}$ = $ClO_4^{\ominus}$, $AsF_6^{\ominus}$, $SbF_6^{\ominus}$, $PF_6^{\ominus}$, $BF_4^{\ominus}$ und/oder $CF_3SO_3^{\ominus}$ ist.

6. Strahlungsempfindliches Gemisch nach Anspruch 5, dadurch gekennzeichnet, daß im Sulfoniumsalz der allgemeinen Formel (I) mindestens einer der Reste $R^1$, $R^2$ und $R^3$ den Rest

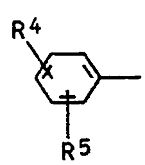

bedeutet, worin $R^4$ und $R^5$ untereinander gleich oder verschieden sind und für H, OH oder den Rest

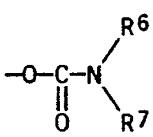

stehen, worin $R^6$ und $R^7$ untereinander gleich oder verschieden sind und für H oder Alkyl mit 1 bis 5 Kohlenstoffatomen stehen, oder $R^6$ mit $R^7$ zu einem fünf- oder sechsgliedrigen, gegebenenfalls ein oder mehrfach substituierten, heterocyclischen Ring verbunden ist.

7. Strahlungsempfindliches Gemisch nach einem der vorhergehenden Ansprüche, dadurch gekennzeichnet, daß die bei Bestrahlung eine starke Säure bildende Verbindung (b) im strahlungsempfindlichen Gemisch in

einer Menge von 1 bis 30 Gew.-%, bezogen auf die Gesamtmenge der Stoffe (a) + (b) enthalten ist.

8. Strahlungsempfindliches Gemisch nach einem der vorhergehenden Ansprüche, dadurch gekennzeichnet, daß als zusätzliche organische Verbindung (c), die eine durch Säure spaltbare Carbamateinheit

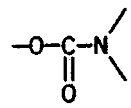

aufweist, eine Verbindung der allgemeinen Formel (II) eingesetzt wird

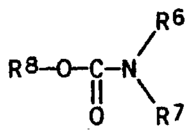

(II),

worin

$R^6$ und $R^7$ untereinander gleich oder verschieden sind und für H oder Alkyl mit 1 bis 5 Kohlenstoffatomen stehen, oder $R^6$ mit $R^7$ zu einem fünf- oder sechsgliedrigen, gegebenenfalls ein- oder mehrfach substituierten, heterocyclischen Ring verbunden ist,

$R^8$ ein geradkettiger oder verzweigter Alkylrest mit 1 bis 10 Kohlenstoffatomen, ein halogenhaltiger geradkettiger oder verzweigter Alkylrest mit 1 bis 10 Kohlenstoffatomen, ein Phenylrest, ein Halogen-, Alkyl- oder Alkoxyphenylrest, ein Phenalkylrest mit 1 bis 3 Kohlenstoffatomen in der Alkylgruppe, ein Halogen- oder Alkoxyphenalkylrest mit 1 bis 3 Kohlenstoffatomen in der Alkylgruppe, oder ein durch einen heterocyclischen Rest substituieren Methyl- oder Ethylrest ist.

9. Strahlungsempfindliches Gemisch nach einem der vorhergehenden Ansprüche, dadurch gekennzeichnet, daß es zusätzlich als Sensibilisator eine polycyclische aromatische Verbindung enthält, die Strahlung absorbiert und auf die bei Bestrahlung eine starke Säure bildende Verbindung (b) überträgt.

10. Verfahren zur Herstellung von Reliefstrukturen oder Reliefmustern durch Auftragen von Photoresistlösungen in einer Schichtdicke von 0,1 bis 5 µm auf ein in üblicher Weise vorbehandeltes Substrat, Trocknen, bildmäßige Bestrahlung, Erhitzen auf Temperaturen von 50 zu 150 °C und Entwickeln mit einer wäßrig-alkalischen Lösung, dadurch gekennzeichnet, daß Photoresistlösungen eingesetzt werden, die strahlungsempfindliche Gemische nach einem der vorhergehenden Ansprüche enthalten.